# EUROPEAN PATENT SPECIFICATION

(11) **EP 1 293 478 B1**
(45) Date of publication and mention of the grant of the patent: **09.03.2016**
(21) Application number: 02256290.4
(22) Date of filing: 11.09.2002
(51) Int. Cl.: B81C 1/00

(54) **Method of sealing electrodes**
Verfahren zur Abdichtung von Elektroden
Méthode pour fermer hérmetiquement des électrodes

(30) Priority: 13.09.2001 GB 0122165
(43) Date of publication of application: 19.03.2003
(73) Proprietor: Randox Laboratories Ltd., Crumlin, County Antrim BT29 4QY (GB)
(72) Inventor: Gamble, Harold S., Down, BT25 1HA (GB); Mitchell, Neil S. J., Down, BT34 1NZ (GB); Rainey, Paul Victor, Belfast, BT7 1SE (GB); Fitzgerald, Stephen Peter c/o Randox Lab. Ltd., Antrim, BT29 4QY (GB)
(74) Representative: Gill Jennings & Every LLP

(56) References cited:
- EP-A- 0 302 654
- WO-A1-01/50106
- US-A- 4 525 766
- US-A- 4 908 112
- RAINEY P ET AL: "FLOW RATE MEASUREMENT VIA CONDUCTIVITY MONITORING IN MICRO-FLUIDIC DEVICES" PROCEEDINGS OF THE SPIE, SPIE, BELLINGHAM, VA, US, vol. 4177, September 2000 (2000-09), pages 185-193, XP008010613 ISSN: 0277-786X
- HILMI A ET AL: "ELECTROCHEMICAL DETECTORS PREPARED BY ELECTROLESS DEPOSITION FOR MICROFABRICATED ELECTROPHORESIS CHIPS" ANALYTICAL CHEMISTRY, AMERICAN CHEMICAL SOCIETY. COLUMBUS, US, vol. 72, no. 19, 1 October 2000 (2000-10-01), pages 4677-4682, XP002938464 ISSN: 0003-2700

## Description

The invention relates to a method of sealing an electrode to a housing.

In the prior art there are a wide range of devices and systems where it is necessary for conductors to pass from inside the structure to the outside world. In many applications the structure must be hermetically sealed to prevent leakage either into or out of the structure. One area of particular importance is in the fabrication of microfluidic devices such as pumps, valves, flow sensors, separation capillaries, and chemical detectors. Many such devices require the incorporation of electrodes within the devices. For example, in a microfluidic device where two or more solutions of different conductivity are present the conductance through the liquid between a pair of electrodes can be measured and the data used to determine which liquid is present or the fraction of the channel occupied by each liquid. The electrodes can also be used as a sensor mechanism where a chemical presence or interaction causes a change in the electrical properties, such as conductance or capacitance, of the liquid within the microanalysis system.

The use of silicon micromachining techniques offers the option of using thin film electrodes located at various positions within the device. A typical fabrication process for microfluidic devices involves the formation of channels, reservoirs etc, in the surface of a silicon wafer using a variety of etching techniques, followed by bonding of a glass lid to form a closed capillary. Electrodes can be incorporated within and along the length of the capillary by formation of thin-film electrodes on the surface of either the glass or the silicon before the bonding step.

For example, US-A-4908112 describes an analytical separation device in which a capillary is formed by etching a channel in a semiconductor substrate and bonding to a glass plate. Electrodes spaced along the channel are used to induce liquid flow without the need for a large voltage along the entire channel.

US-A-5906723 describes a capillary electrophoresis chip that includes a thin-film electrochemical detector, consisting of platinum electrodes that are photolithographically defined on the bottom substrate before bonding to the cover substrate. It was noted that the conductors are preferably inset into the substrate to enable effective sealing of the cover.

Some measurement techniques, e.g. where a.c. signals can be used, do not require direct contact between the liquid and the metal electrodes. In these situations the electrode could be encased in a chemical-resistant and electrical-insulating layer.

W. Olthuis et al. "Planar interdigitated electrolyte-conductivity sensors on an insulating substrate covered with Ta2O5" Sensors & Actuators.B43 (1997) pp211-216, describe the use of a thin insulating Ta₂O₅ film to cover platinum electrodes and prevent fouling from chemicals.

An alternative approach to the problem is the frequent replacement of electrodes after fouling, by the techniques of screen printing as reported by J. Wang et al, Anal. Chem., 1999, 71(23), pp5436-5440 or electroless deposition as reported by A.Hilmi et al Anal. Chem., 2000, 72 (19), pp4677-4682.

In many of these devices it was either necessary or highly desirable to incorporate electrodes at specific points along the length of the channel(s) as well as in the inlet/outlet reservoirs. In the case of multi-channel devices, independent measurements could be performed on each channel. Electrodes spaced at close intervals along the channel would provide improved flow rate resolution especially where a small packet of one liquid surrounded by another is passing along the channel.

The metal selected for the thin-film electrodes needs to withstand the anodic bonding temperatures, generally 350-600°C, and must resist corrosion by the liquids. Whilst aluminium is a commonly used metal in integrated circuit processing, electrodes formed from aluminium would be extensively damaged during the anodic bonding process, because of the high temperatures involved. Aluminium is also susceptible to chemical attack from many of the solutions commonly used in chemical analysis. Metals such as gold and platinum are more suitable due to their good chemical and electrical properties. Unfortunately the adhesion of these metals to glass and oxidised silicon is poor so a thin interface layer of another material is also required. Titanium, tungsten and chromium are examples of commonly used adhesion metals. In addition, gold forms a low temperature eutectic with silicon that can cause problems during fabrication. A diffusion barrier layer is thus required. Ideally the same material could be used for both adhesion and barrier functions. Suitable materials include titanium, tungsten and chromium.

To maintain a hermetic seal, the electrodes must be thin enough to avoid a large step that could result in voids after bonding, which would cause leaks in the channels. For example, WO-A-8503381 reports that metal electrodes with a thickness greater than about 50 nm will result in "tenting" - the creation of an air or liquid passage at the electrode-silicon interface. WO-A-8503381 also describes a method whereby planar projections at the electrode sides could form hermetic seals. The preferred metal, titanium, is very susceptible to oxidation during subsequent processing including the anodic bonding stage and is also not compatible with the liquids used in many microfluidic devices. In addition, the projections may need to be quite large in the case of thicker metal layers and they will thus limit the minimum electrode spacing for reliable bonding.

Reducing electrode thickness to avoid the sealing problem will render the electrodes susceptible to oxidation and chemical reaction, which will degrade their electrical conductivity. When the electrode is thin, the possibility of micro-pinholes in the gold exists. These pinholes provide a path for oxygen to pass to the diffusion barrier layer leading to the oxidation of titanium and removal of its barrier properties. In the final structure these pinholes can also allow contact between the solution in the capillary and the barrier material with the potential for corrosion of the electrodes.

In Proc. SPIE Vol.4177, pp185-193, 2000, "Flow rate measurement via conductivity monitoring in microfluidic devices" P.Rainey et al, used titanium as the adhesion layer and also to provide a barrier to the migration of gold into the substrate. Degradation of 50 nm thick electrodes was observed during the anodic bonding process, mainly in the regions exposed to the atmosphere. The degradation mechanism proposed was that oxygen passed though pinholes in the gold layer causing oxidation of the titanium and removal of the titanium diffusion barrier. Etch tests confirmed the presence of pinholes in the thin gold layer.

In document WO01/50106 an electrode is sealed within a housing.

To overcome the corrosion it is desirable to use thicker metal layers for the gold electrodes. This can be achieved by recessing the electrodes in either the glass or silicon substrates if the bonding problems are to be avoided. However, if the electrode top surface is below the glass surface (by 50nm or more) there could be an incomplete seal after bonding, resulting in leakage from the channel along the electrode surface. The leakage may be aided by the electro-wetting phenomenon where liquid is drawn along a metal surface when voltage is applied to the electrode.

A further problem is that the standard methods, such as etching and lift-off, used to pattern the electrode stacks leave the edges of the barrier/adhesion layer exposed and therefore vulnerable to oxidation/corrosion.

In accordance with the present invention, a method of sealing an electrode to a housing, comprises:
1) providing a layer of electrode material on a surface of a first housing part;
2) securing a second housing part to the first housing part with the layer of electrode material located in a fluid channel between them; and thereafter
3) flowing additional electrode material to the electrode layer along the fluid channel so as to increase the thickness of the electrode layer and seal the electrode to the housing defined by the two housing parts.

The present invention describes a process, which has been devised to overcome the problems of hermetic sealing and electrode corrosion. The process involves in the preferred example forming seed electrode patterns on the surface of one substrate or first housing part; bonding to a second substrate or second housing part; and increasing the thickness of the seed electrodes by selective deposition or plating of additional material. In a preferred embodiment of the method the seed electrodes would be formed in shallow recesses.

Some examples of methods according to the invention will now be described with reference to the accompanying drawings, in which:-
Figures 1-6 are schematic cross-sections illustrating successive stages in a first example of the method;
Figures 7-9 are schematic cross-sections illustrating successive stages in a second example of the method;
Figure 10 is a schematic plan view of a microfluidic device with thin film electrodes; and
Figure 11 is a schematic cross-section along one channel of a micro-machined silicon device similar to that shown in Figure 10.

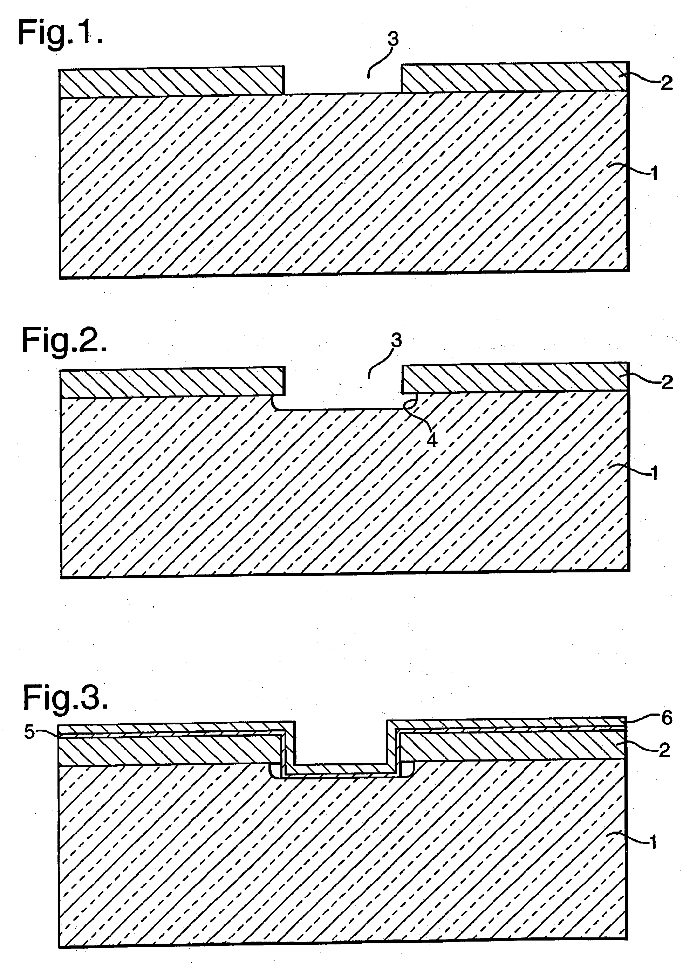

A preferred embodiment of the method is shown in the sequence of cross-sectional diagrams, Figure 1 - Figure 6. In this case the substrate material 1 is glass, alternative substrates such as silicon or oxidised silicon may be employed.

The substrate 1 is first covered in a layer of photoresist 2 using standard methods. This is exposed through a mask and developed to remove the photoresist from the regions 3 where electrodes are to be formed as shown in Figure 1.

The substrate 1 is then etched, as shown in Figure 2 at 4, to a depth slightly greater than the desired electrode thickness. In the case of a glass substrate, or silicon dioxide coated silicon substrate, this etching could typically be achieved using a hydrofluoric acid mixture. Other etching methods, including ion beam milling and reactive ion etching, are also possible.

An adhesion/barrier layer 5 and electrode metal layer 6 are then deposited, Figure 3. The deposition may be performed by one of several standard methods, such as evaporation or sputtering. Typical adhesion/barrier materials 5 include, titanium, tungsten and chromium. The electrode material 6 is typically platinum or gold.

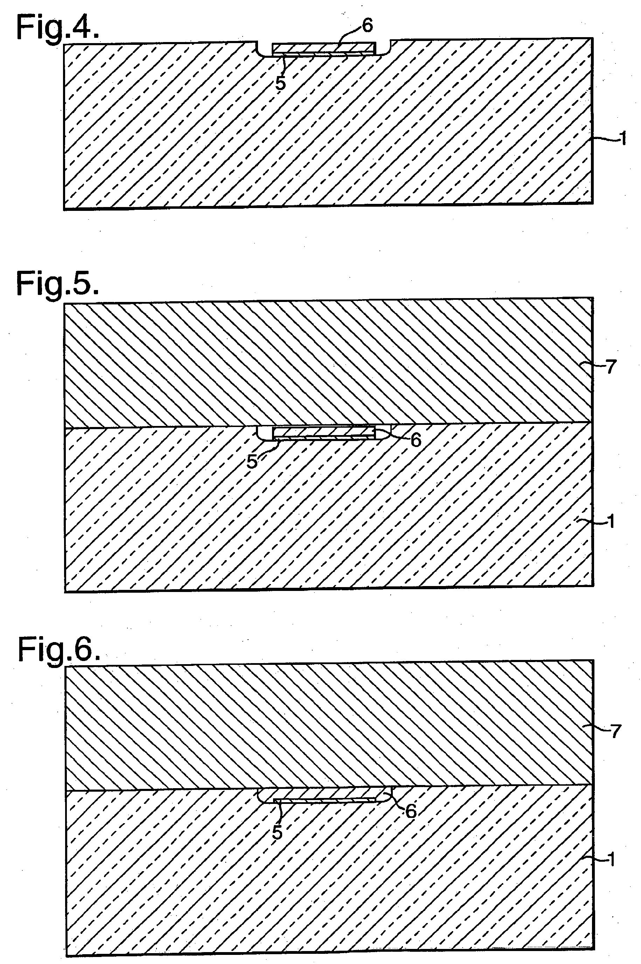

The photoresist 2 is then dissolved and in the process removes the overlying metal layers in a method referred to as lift-off, Figure 4.

In Figure 5, the substrate 1 complete with electrodes 6 is bonded to a second substrate 7 to form the fluid channels. In this implementation, the electrodes are shown only on the glass substrate 1, in alternative embodiments electrodes may be present on both substrates or on the upper substrate 7 only.

The final and key stage in the process is the thickening of the electrodes by selective growth of additional metal 6 as shown in Figure 6. In this preferred embodiment, the selective deposition is by chemical plating with the plating solution allowed to flow along the fluid channels. During the plating process, additional metal will be grown on the metal electrode surfaces and will serve two functions. The metal will grow to fill any narrow spaces between the top of the electrode 6 and the opposite substrate 7. It is not necessary that the gap be filled along the entire length of the electrode, but only at the edges of the flow channel to form a hermetic seal. The plated metal will encapsulate the edges of the electrodes and prevent subsequent corrosion of the adhesion/barrier layer during device operation.

There are two main options for the plating process. Electroplating can be employed, whereby an electric current flows through the plating solution in the channel between an external electrode and the thin-film electrodes. In the process, metal ion reduction will occur leading to metal deposition on the thin-film electrodes. Alternatively an electro-less plating method can be employed. The method involves the use of chemical reducing agents and does not require an external current source or additional electrodes. Electro-less plating is also reported to avoid dendrite formation and produce more even deposition in situations where non-uniform current densities may occur with electroplating.

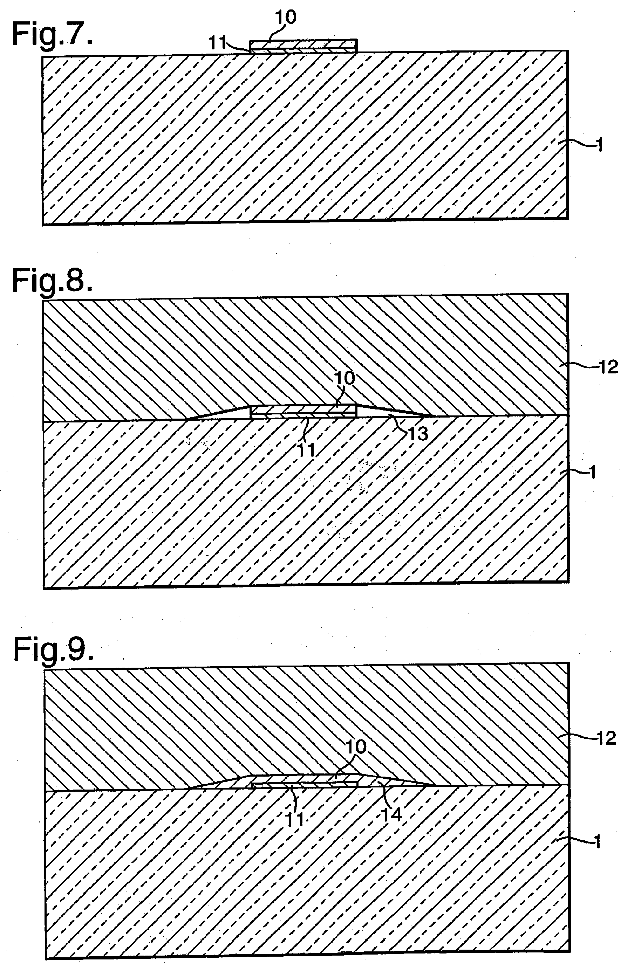

In an exemple of the method, the seed electrodes 10 may be formed directly (using an adhesion/barrier layer 11 in this case) on the surface of the first substrate 1 as shown in Figure 7. Bonding to a second substrate 12 may resulting in 'tenting' and void formation 13 at the electrode edges as illustrated in Figure 8. Selective deposition 14 on the seed electrode 10 is then performed to increase the thickness of the seed electrode and grow material to seal the voids as shown in Figure 9. However, this configuration limits the minimum electrode spacing, which may reduce the number of possible electrodes per channel.

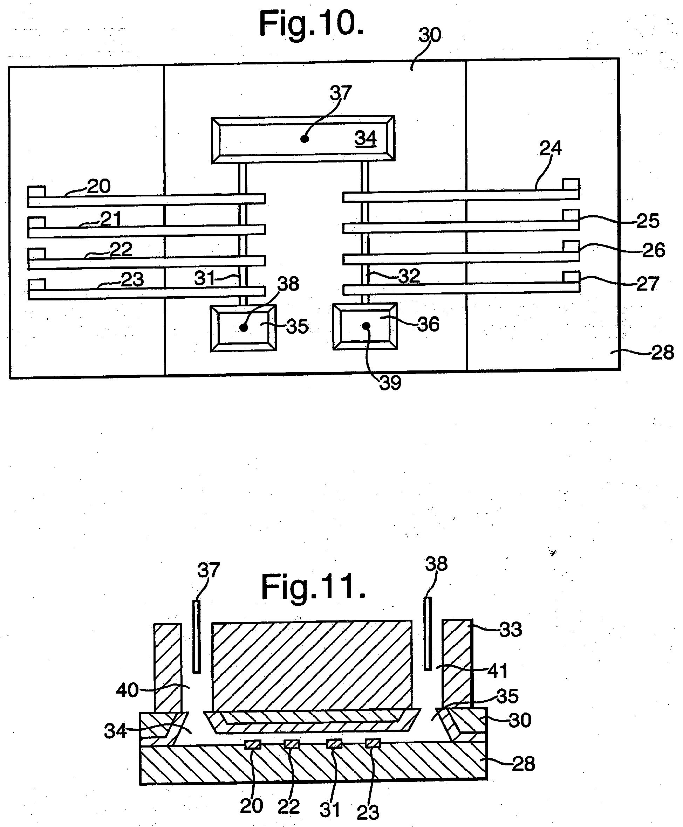

Figures 10 and 11 illustrate a microfluidic device with eight gold, thin film electrodes 20-27. These have been deposited on a glass substrate 28 and sealed to an upper silicon substrate 30 using one of the method previously described. The silicon substrate 30 defines a pair of fluid flow channels 31, 32 extending orthogonally to the electrodes 20-27, communicating with holes 34-36, and across which the electrodes extend as can be seen in the drawings.

A perspex cover 33 is bonded on top of the silicon substrate 30 and defines three openings, two of which 40, 41 can be seen in Figure 11, and into which respective platinum electrodes 37-39 extend. These openings are aligned with respective holes 34-36. The platinum electrodes can be used to induce electro-osmotic flow along a given channel. For example, application of high voltage applied between platinum electrodes 34 and 35, will cause liquid to flow along channel 31 with the thin-film electrodes 24-27 used to monitor conductance of liquid in each zone of the channel.

Test structures based on the above fabrication principles have been produced. In-channel electroplating was performed by fabricating sputtered Au-Ti electrodes on glass, anodically bonding to oxidized through-etched silicon, and placing the Si-glass pair directly into the plating bath. When performing in-channel plating, the current is limited to the micro amp region, because of the narrow cross-sectional area of the channel. However, since the exposed area of each electrode is very small (50µm × 0.5mm), the current density was within the optimum density suggested by the suppliers.

Corrosion tests were performed on both plated and unplated electrodes. The unplated electrodes were at least 50% corroded after 5 minutes. Electrodes that were plated with gold showed no corrosion for over 20 minutes.

## Claims

1. A method of sealing an electrode to a housing, the method comprising:
1) providing a layer of electrode material (6) on a surface of a first housing part (1);
2) securing a second housing part (7) to the first housing part (1) with the layer of electrode material (6) located in a fluid channel between them; and thereafter
3) flowing additional electrode material to the electrode layer along the fluid channel so as to increase the thickness of the electrode layer (6) and seal the electrode to the housing defined by the two housing parts (1,7).

2. A method according to claim 1, wherein step 1 comprises deppsiting an adhesion/barrier layer (5) on the first housing part (1) followed by the layer of electrode material (6).

3. A method according to claim 2, wherein the adhesion/ barrier layer (5) comprises titanium, tungsten or chromium.

4. A method according to any of the preceding claims, wherein the electrode material (6) comprises platinum or gold.

5. A method according to any of the preceding claims, wherein the fluid channel with the layer of electrode material is provided by an elongate channel in the first housing part (1).

6. A method according to any of the preceding claims, wherein the electrode material layer (6) and any adhesion/barrier layer is deposited on the first housing part (1) by evaporation or sputtering.

7. A method according to any of the preceding claims, wherein step 3 comprises electro-plating or electroless plating of additional electrode material.

8. A method according to any of the preceding claims, wherein the thickness of the fluid channel in step 2) is such that a gap is formed between the second housing part (7) and the layer of electrode material (1).

## Patentansprüche

1. Verfahren zur Abdichtung einer Elektrode an ein Gehäuse, wobei das Verfahren umfasst:
1) Bereitstellen einer Schicht aus Elektrodenmaterial (6) auf einer Oberfläche eines ersten Gehäuseteils (1);
2) Befestigen eins zweiten Gehäuseteils (7) an das erste Gehäuseteil (1), wobei sich die Schicht aus Elektrodenmaterial (6) in einem Flüssigkeitskanal zwischen diesen befindet; und danach
3) Fließen lassen von zusätzlichem Elektrodenmaterial zur Elektrodenschicht entlang des Flüssigkeitskanals, um die Dicke der Elektrodenschicht (6) zu vergrößern und die Elektroden an das Gehäuse abzudichten, das von den zwei Gehäuseteilen (1, 7) definiert wird.

2. Verfahren nach Anspruch 1, wobei der Schritt 1 das Ablagern einer Adhäsions-/Sperrschicht (5) am ersten Gehäuseteil (1), gefolgt von der Schicht aus Elektrodenmaterial (6) umfasst.

3. Verfahren nach Anspruch 2, wobei die Adhäsions-/Sperrschicht (5) Titan, Wolfram oder Chrom umfasst.

4. Verfahren nach irgendeinem der vorhergehenden Ansprüche, wobei das Elektrodenmaterial (6) Platin oder Gold umfasst.

5. Verfahren nach irgendeinem der vorhergehenden Ansprüche, wobei der Flüssigkeitskanal mit der Schicht aus Elektrodenmaterial von einem länglichen Kanal im ersten Gehäuseteil (1) bereitgestellt wird.

6. Verfahren nach irgendeinem der vorhergehenden Ansprüche, wobei die Elektrodenmaterialschicht (6) und irgendeine Adhäsions-/Sperrschicht (5) durch Aufdampfen oder Sputtern auf das erste Gehäuseteil (1) abgelagert wird.

7. Verfahren nach irgendeinem der vorhergehenden Ansprüche, wobei der Schritt 3 Elektroplattierung oder stromlose Plattierung von zusätzlichem Elektrodenmatrial umfasst.

8. Verfahren nach irgendeinem der vorhergehenden Ansprüche, wobei die Dicke des Flüssigkeitskanals in Schritt 2) derart ist, dass ein Spalt zwischen dem zweiten Gehäuseteil (7) und der Schicht aus Elektrodenmaterial (1) gebildet wird.

## Revendications

1. Méthode de scellage d'une électrode sur un encastrement, la méthode consistant:
1) à prévoir une couche de matériau pour électrode (6) sur la surface d'une première partie (1) de l'encastrement;
2) à fixer une deuxième partie (7) de l'encastrement sur la première partie (1) de l'encastrement, la couche de matériau qui constitue l'électrode (6) étant située dans un canal de fluide entre ces deux parties; et ensuite
3) à faire couler un flux supplémentaire de matériau constituant l'électrode vers la couche-électrode le long du canal de fluide de manière à accroître l'épaisseur de la couche-électrode (6) et sceller l'électrode à l'encastrement défini par les deux parties de l'encastrement (1, 7).

2. Méthode selon la revendication 1, **caractérisée en ce que** l'étape 1 consiste entre autres à déposer une couche d'adhésion/barrière (5) sur la première partie (1) de l'encastrement suivie de la couche de matériau constituant l'électrode (6).

3. Méthode selon la revendication 2, **caractérisée en ce que** la couche d'adhésion/barrière (5) est faite de titane, de tungstène ou de chrome.

4. Méthode selon l'une quelconque des revendications précédentes, **caractérisée en ce que** l'électrode est réalisée (6) en platine ou en or.

5. Méthode selon l'une quelconque des revendications précédentes, **caractérisée en ce que** le canal de fluide doté de la couche de matériau constituant l'électrode est un canal allongé prévu dans la première partie (1) de l'encastrement.

6. Méthode selon l'une quelconque des revendications précédentes, **caractérisée en ce que** la couche de matériau constituant l'électrode (6) et toute couche d'adhésion/barrière (5) éventuelle est déposée sur la première partie (1) de l'encastrement par vapeur de plasma ou par pulvérisation.

7. Méthode selon l'une quelconque des revendications précédentes, **caractérisée en ce que** l'étape 3 consiste entre autres à déposer électrolytiquement ou par revêtement auto-catalytique une quantité supplémentaire de matériau constituant l'électrode.

8. Méthode selon l'une quelconque des revendications précédentes, **caractérisée en ce que** l'épaisseur du canal de fluide de l'étape 2) est prévue de manière à ce que soit formé un intervalle entre la deuxième partie (7) de l'encastrement et la couche de matériau constituant l'électrode (1).
